# EUROPÄISCHE PATENTSCHRIFT

(11) **EP 2 719 264 B1**
(45) Veröffentlichungstag und Bekanntmachung des Hinweises auf die Patenterteilung: **17.08.2016**
(21) Anmeldenummer: 12727313.4
(22) Anmeldetag: 07.06.2012
(51) Int. Cl.: H05K 3/00, H05K 1/14, H05K 1/02, H05K 3/46

(54) **VERFAHREN ZUM HERSTELLEN VON LEITERPLATTEN UND LEITERPLATTENGESAMTNUTZEN**
METHOD FOR PRODUCING CIRCUIT BOARDS AND COMPLETE CIRCUIT BOARD PANELS
PROCÉDÉ DE FABRICATION DE CARTES DE CIRCUITS IMPRIMÉS ET UTILISATION INTÉGRALE DE CARTES DE CIRCUITS IMPRIMÉS

(30) Priorität: 09.06.2011 DE 102011106104
(43) Veröffentlichungstag der Anmeldung: 16.04.2014
(73) Patentinhaber: Otto Bock Healthcare Products GmbH, 1070 Wien (AT)
(72) Erfinder: EDER, Marcus, A-1090 Wien (AT)
(74) Vertreter: Stornebel, Kai
(86) Internationale Anmeldenummer: PCT/EP2012/002426
(87) Internationale Veröffentlichungsnummer: WO 2012/167937

(56) Entgegenhaltungen:
- EP-A1- 2 180 771
- DE-A1- 4 134 172
- DE-A1- 4 319 944
- DE-A1- 10 027 732
- GB-A- 775 267
- JP-A- H0 284 282
- US-A- 5 721 044
- US-B1- 6 207 221

## Beschreibung

Die Erfindung betrifft ein Verfahren zum Herstellen bestückter oder unbestückter Leiterplatten oder Einzelschaltungen als Einzelnutzen aus einem Gesamtnutzen mit einem Leiterplattengrundmaterial, bei dem der jeweilige Einzelnutzen aus dem Gesamtnutzen mit einem Laser entfernt wird. Die Erfindung betrifft ebenfalls einen Leiterplattengesamtnutzen mit einer Vielzahl von Einzelnutzen bestückter oder unbestückter Leiterplatten oder Einzelschaltungen.

Die US 2009/0026168 A2 beschreibt ein Verfahren zum Herstellen von festflexiblen Leiterplatten mit einer flexiblen Leiterplatte mit einer zwischengelagerten Basisschicht, die zwischen zwei Lagen mit elektrischen Schaltkreisen angeordnet ist. Die beiden Schichten sind mit den Kupferschaltkreisen mit einer Schutzschicht auflaminiert, auf die wiederum eine dielektrische Schicht auflaminiert wird, auf die wiederum eine Kupferfolie auflaminiert wird. Eine feste Leiterplattenstruktur wird zwischen zwei starren Teilen ausgebildet, die dadurch flexibel miteinander verbunden sind, dass die dielektrische Schicht vorbestimmte Freiräume aufweist. In einem ersten Schneidverfahren wird das dielektrische Material an einer Schnittstelle zwischen einem Liegebereich und dem starren Teil durch Ausbilden einer ersten Nut unter Freilegung eines Teils der Kupferfolie entfernt. In einem zweiten Schneidprozess wird seitlich versetzt zu der ersten Nut eine zweite Nut eingeschnitten und die gegenüberliegende Kupferschicht freigelegt. Anschließend findet ein Ätzverfahren statt, um die freigelegte Kupferfolie am Boden der ersten Nut zu entfernen, wodurch eine zweite Nut entsteht, die mit der vorab ausgebildeten Öffnung in Verbindung steht. Die noch verbliebene, feste Struktur wird in dem Biegebereich entfernt.

Dieses Verfahren ist sehr aufwendig und sieht neben dem Heraustrennen von Teilschichten mittels Laserstrahl den Einsatz von ätzenden Chemikalien und gegebenenfalls mechanischen Trennwerkzeugen vor.

Die US 6,207,221 B1 (vgl. den Oberbegriff der Ansprüche 1 und 7) betrifft ein Verfahren zum Herstellen eines Keramik-Metall-Substrats für elektrische Schaltkreise, bei dem auf den Oberseiten einer Keramikschicht Metallschichten oder auch Schaltkreise aufgebracht werden. In der Keramikschicht sind Sollbruchlinien eingearbeitet, entlang derer die Keramikschicht durchbrochen werden kann. Die Sollbruchlinien können über einen Laser in die Keramikschicht eingebracht werden.

Aus der JP H02 84282 A und der GB 775,267 A sind jeweils Verfahren bekannt, bei denen eine Keramikschicht durch einen Laser abgetragen wird bis der Laser auf eine im keramischen Material oder an der Unterseite des keramischen Materials angeordnete Metallschicht trifft.

Aus der DE 41 34 172 A1 ist eine Verbindungsvorrichtung für elektronische Bauelemente bekannt. Dabei wird die Verbindungsvorrichtung durch Bearbeiten einer Trägerplatte aus einem rostfreien Stahl hergestellt. Nach der Herstellung verschiedener Einzelnutzen auf einem Gesamtnutzen werden diese aus dem Gesamtnutzen mittels eines Laserstrahls bis auf zurückbleibende kleine Stege an den Ecken der Einzelnutzen herausgeschnitten. Diese bestehen aus unterschiedlichen Schichten aus einem Dielektrikum und einem Bindemittel sowie wenigstens einer Metallschicht, die mit der Leistungsebene der Einzelnutzen verbunden ist. Sollen die Einzelnutzen aus dem Gesamtnutzen herausgetrennt werden, werden diese Verbindungsstege zerbrochen.

Die DE 100 27 732 A1 offenbart eine Mehrfachnutzenleiterplatte, bei der zwischen den verschiedenen Einzelnutzen Ritz- oder Trennlinien vorgesehen sind, sodass an diesen Stellen der jeweilige Einzelnutzen aus dem Gesamtnutzen herausgebrochen werden kann. Dabei werden beidseitig annähernd fluchtend gegenüberliegend Ritzlinien mittels eines Laserstrahls in das Plattenmaterial eingebracht.

Die EP 2 180 771 A1 offenbart ein Verfahren zum Herstellen einer Leiterplatte, die aus mehreren unterschiedlich großen Leiterplatten zusammengesetzt ist. Dabei werden vier Einzelleiterplatten paarweise aneinander angelegt. Die ersten beiden Leiterplatten sind unterschiedlich groß, sodass es hier zu einem Überhang kommt. Die zweiten zwei Leiterplatten können gleich groß oder verschieden groß ausgebildet sein und sind mit den ersten beiden Leiterplatten über ein biegbares Element verbunden. Damit soll die Stör- und Schadensanfälligkeit von Leiterplatten verringert werden.

Aufgabe der vorliegenden Erfindung ist es, ein Verfahren und einen Leiterplattennutzen herzustellen, mit dem eine konturgenaue, splitterfreie Trennung von Einzelnutzen aus einem Leiterplattengesamtnutzen ermöglicht wird.

Erfindungsgemäß wird diese Aufgabe durch ein Verfahren mit den Merkmalen des Hauptanspruches und einem Leiterplattengesamtnutzen mit den Merkmalen des nebengeordneten Anspruchs gelöst. Vorteilhafte Ausgestaltungen und Weiterbildungen der Erfindung sind in den Unteransprüchen, der Beschreibung sowie den Figuren offenbart.

Das erfindungsgemäße Verfahren zum Herstellen bestückter oder unbestückter Leiterplatten oder Einzelschaltungen als Einzelnutzen aus einem Gesamtnutzen mit einem Leiterplatteng-rundmaterial, bei dem der jeweilige Einzelnutzen aus dem Gesamtnutzen mit einem Laser entfernt wird, sieht vor, dass vor dem Entfernen des Einzelnutzens aus dem Gesamtnutzen dieser über Metallanbindungen an dem Gesamtnutzen befestigt wird, dass das Leiterplattengrundmaterial bis auf die Metallanbindungen entfernt und dass der Einzelnutzen nach dem Entfernen des Leiterplattengrundmaterials von dem Gesamtnutzen getrennt, insbesondere herausgedrückt wird. Die Metallanbindungen, die über den Umfang des Einzelnutzens hinausragen, legen den Einzelnutzen an dem Gesamtnutzen fest, wenn das Leiterplattengrundmaterial vollumfänglich entfernt worden ist. Die Metallanbindungen ragen dabei vor-zugsweise von dem Gesamtnutzen in die Kontur des Einzelnutzens hinein, wobei keine vollständige Abdeckung des Einzelnutzens durch die Metallanbindungen bzw. die Metallanbindung bewirkt wird. Der Einzelnutzen ist somit nicht vollständig durch die Metallanbindung hinterlegt, sondern nur in einem Bereich, der sich an den äußeren Umfang des Einzelnutzens anschließt. Die Einzelnutzen, die als bestückte oder unbestückte Leiterplatten oder als Einzelschaltungen ausgebildet sind und zu einem Gesamtnutzen zusammengefasst sind, werden vor dem Heraustrennen aus dem Gesamtnutzen mit Metallanbindungen versehen. Die Leiterplatten oder Einzelschaltungen bestehen dabei regelmäßig aus mehreren Schichten eines Leiterplattengrundmaterials, überwiegend einem Kunststoff oder einem faserverstärkten Kunststoff, die mit gedruckten, in der Regel metallischen Schaltungen versehen sind. Diese Schaltungen können auch dreidimensional angeordnet sein und nicht nur flächig, sondern auch innerhalb des Leiterplattengrundmaterials geschichtet erstrecken. Mehrere unterschiedliche oder auch gleichartige Leiterplatten oder Einzelschaltungen werden zu einem Gesamtnutzen bei der Herstellung zusammengefasst, um das Herstellverfahren rationaler zu gestalten. Die jeweils voneinander unabhängigen Einzelnutzen werden dann vorzugsweise über einen Laser ausgeschnitten, wobei der Laser das Leiterplattengrundmaterial entfernt, indem die Kontur des Einzelnutzens abgefahren wird. Dadurch ergibt sich ein glatter, splitterfreier Rand am Umfang des Einzelnutzens. Um zu verhindern, dass der jeweilige Einzelnutzen aus dem Gesamtnutzen herausfällt, wenn der Laser die Kontur einmal abgefahren hat, sind die Metallanbindungen vorgesehen, die die Einzelnutzen solange an dem Gesamtnutzen halten, bis sie kontrolliert aus dem Gesamtnutzen herausgelöst, vorzugsweise herausgedrückt werden.

Zur Entfernung des Leiterplattengrundmaterials wird vorzugsweise ein CO2-Laser eingesetzt, der das Leiterplattengrundmaterial entfernt, die Metallanbindungen, beispielsweise Kupferfolie, jedoch nicht durchtrennt. Dazu wird die Leistung auf ein entsprechendes Niveau eingestellt.

Die Metallanbindungen werden vorzugsweise an den Eckbereich und/oder an Teilbereichen der Kontur der jeweiligen Einzelnutzen angebracht, so dass nur noch eine abschnittsweise Anbindung der Einzelnutzen an dem Gesamtnutzen über die Metallanbindungen vorhanden ist und das Trennen der Einzelnutzen von dem Gesamtnutzen mit einem geringen Kraftaufwand erfolgen kann.

Das Leiterplattengrundmaterial wird vorzugsweise herausgeschnitten, wobei sich das Herausschneiden mit einem Laserstrahl als besonders geeignet erwiesen hat. Selbst kleinste Leiterplatten mit einer umlaufenden Kontur können so gefertigt werden, ohne dass nach dem Trennen der Einzelnutzen aus dem Gesamtnutzen eine Nachbearbeitung der Kontur erfolgen müsste. Grundsätzlich sind auch andere Trennverfahren möglich und vorgesehen, um das Leiterplattengrundmaterial zu entfernen.

Als Metallanbindungen werden insbesondere Kupferanbindungen, insbesondere Kupferpads, aufgebracht. Dies hat den Vorteil, dass keine gesonderten Verfahrenstechniken eingesetzt werden müssen, da Kupfer bereits für die Schaltungen auf den Leiterplatten eingesetzt wird. Grundsätzlich sind jedoch auch andere Metallanbindungen möglich, wenn dies erforderlich sein sollte.

Eine Weiterbildung der Erfindung sieht vor, dass die Metallanbindungen auf nur einer Oberfläche des Gesamtnutzens oder zwischen zwei Werkstofflagen des Leiterplattengrundmaterials angeordnet werden, wobei die Anordnung auf nur einer der Oberflächen des Gesamtnutzens den Vorteil hat, dass der gesamte Randbereich splitterfrei und konturgenau in einer Aufspannung in einen Arbeitsgang herausgeschnitten werden kann.

Vor dem Trennen des Einzelnutzens und nach dem Entfernen des Leiterplattengrundmaterials kann eine Bearbeitung des Einzelnutzens erfolgen, beispielsweise eine Bestückung mit Komponenten, den sogenannten SMD (Surface Mounted Device). Eine Bestückung mit Komponenten kann auch vor dem Entfernen des Leiterplattengrundmaterials erfolgen.

Ein Leiterplattengesamtnutzen mit einer Vielzahl von Einzelnutzen bestückter oder unbestückter Leiterplatten oder Einzelschaltungen sieht vor, dass die Einzelnutzen oder zumindest eine Metallanbindung an dem Leiterplattengrundmaterial befestigt sind. Diese Metallanbindungen können als Metallfolie, insbesondere als Kupferfolie ausgebildet sein, um eine einfache Trennung der Einzelnutzen aus dem Gesamtnutzen durch ein werkzeugloses Herauslösen zu ermöglichen, wenn das Leiterplatten-grundmaterial die Kontur des jeweiligen Einzelnutzens entfernt worden ist.

Die Metallanbindungen können so angeordnet sein, dass nur Teile der Kontur des Einzelnutzens überlappt werden, wobei die Überlappung vorteilhafter Weise an den Eckbereichen vorhanden ist, an denen in der Regel eine geringere Schaltungs- und Bauteildichte vorhanden ist.

Sofern die Metallanbindung an einer Oberfläche des Leiterplattengrundmaterials angeordnet ist, kann der Einzelnutzen nach dem Entfernen des Leiterplattengrundmaterials um die Kontur des Einzelnutzens herum leicht herausgedrückt werden, da sich der überlappende Bereich der Metallanbindung oder der Metallfolie, der in den Einzelnutzen hineinragt, leicht von der Oberfläche des Leiterplattengrundmaterials ablösen lässt. Sofern sämtliche Metallanbindungen auf einer gemeinsamen Seite des Leiterplattengesamtnutzens angeordnet sind, lassen sich die Einzelnutzen sehr schnell durch eine gemeinsame Relativbewegung des Leiterplattengesamtnutzens zu den jeweiligen Einzelnutzen voneinander trennen. Die Metallanbindung kann als separate Komponente ohne Kontaktierung zu einer Schaltung ausgebildet sein, so dass eine Beeinträchtigung der Leiterplattenschaltung oder der Einzelschaltung in funktionaler Hinsicht nicht gegeben ist, wenn eine Verformung der Metallanbindung beim Herausdrücken auftritt. Eine mechanische Beeinflussung der Einzelnutzen erfolgt daher nicht oder nur in einem außerordentlich geringen Umfang, so dass eine mechanische Schädigung der Einzelnutzen nicht zu erwarten ist.

Nachfolgend wird ein Ausführungsbeispiel der Erfindung anhand der beigefügten Figuren näher erläutert. Es zeigen:
- Figur 1: eine Draufsicht auf einen Leiterplattengesamtnutzen mit Einzelnutzen;
- Figur 2: eine Draufsicht auf einen Leiterplattengesamtnutzen nach der Entfernung der Einzelnutzen; sowie
- Figuren 3 bis 5: eine schematische Darstellung des Trennens eines Einzelnutzens.

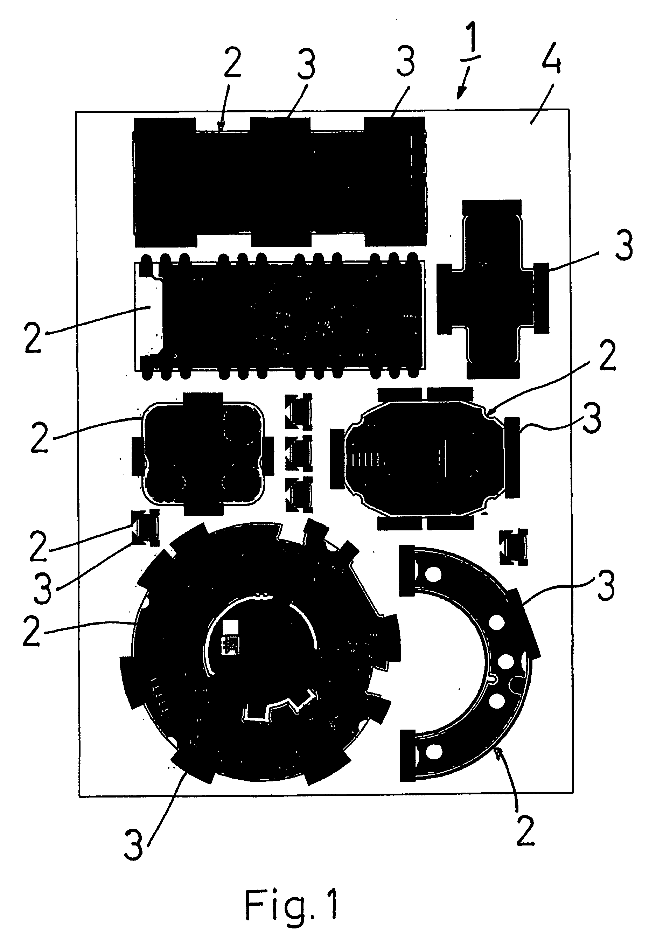

In der Figur 1 ist in einer Draufsicht ein Gesamtnutzen 1 mit mehreren, darin angeordneten Einzelnutzen 2 dargestellt. Die Einzelnutzen 2 sind als bestückte oder unbestückte Leiterplatten oder als Einzelschaltungen ausgebildet und werden nach den üblichen Herstellungsverfahren hergestellt. Der mehrschichtige Aufbau wird später erläutert werden. Dargestellt ist eine Untenansicht, wobei die jeweiligen Einzelnutzen 2 getrennt voneinander ausgebildet sind, so dass die jeweiligen Leiterplatten oder Einzelschaltungen einzeln separiert werden können.

Der Gesamtnutzen 1 weist ein Leiterplattengrundmaterial 4 auf, aus und auf dem die einzelnen Leiterplatten oder Einzelschaltungen aufgebaut sind. Innerhalb und oberhalb des Leiterplattengrundmaterials 4 sind elektrische Schaltungen und Schaltkreise eingearbeitet oder angeordnet, was später erläutert werden wird. Auf der Oberfläche des Gesamtnutzens 1 sind Metallanbindungen 3 aufgebracht, die in Gestalt von Metallfolienstücken ausgebildet sind. Diese Metallanbindungen 3 befinden sich größtenteils außerhalb der Kontur des jeweiligen Einzelnutzens 2 und ragen in die Kontur des jeweiligen Einzelnutzens 2 hinein. Dort sind sie mit einem Teil der Oberfläche einer Seite des Einzelnutzens 2 verbunden, so dass sie durch die Metallanbindungen 3 an dem Gesamtnutzen 1 festgelegt sind, wenn die Einzelnutzen von dem Leiterplattengrundmaterial 4 getrennt werden. In der Figur 1 sind verschiedene Ausgestaltungen von Einzelnutzen 2 dargestellt, neben runden, halbkreisförmigen und eckigen sind auch sternförmige oder ovale Einzelnutzen 2 in Gestalt von Leiterplatten oder dergleichen vorgesehen. Die Anordnung der Metallanbindungen 3 ist dabei so gewählt, dass nicht zwingend eine elektrische Kontaktierung mit einem elektrischen Schaltelement oder Schaltkreis auf den jeweiligen Leiterplatten 2 oder Einzelschaltungen 2 erfolgt. Auf dem Einzelnutzen 2 können SMD angeordnet sein, die Anordnung von SMD oder anderen elektrischen Komponenten kann jedoch auch erst nach dem Trennen der Einzelnutzen 2 aus dem Gesamtnutzen 1 erfolgen.

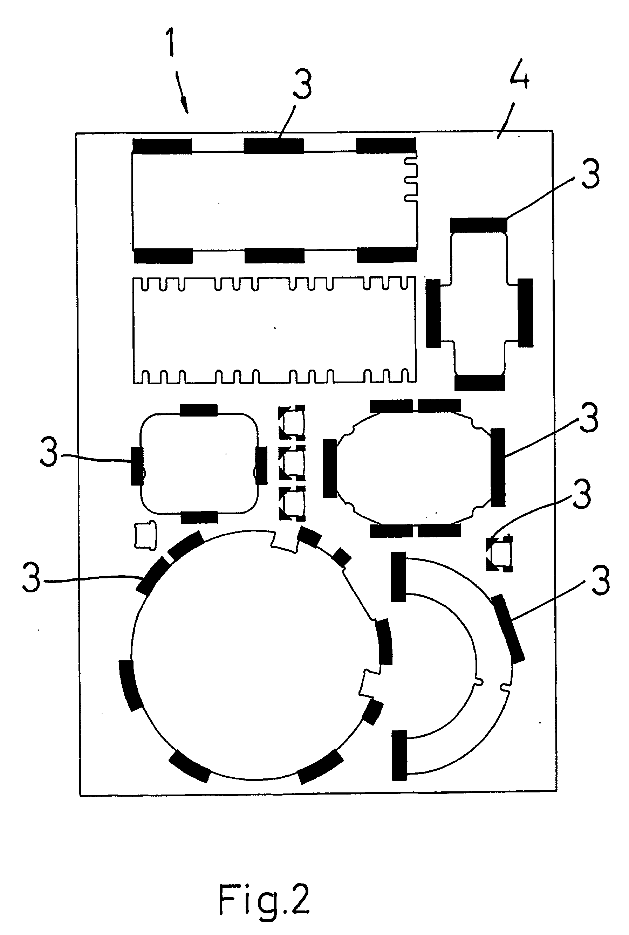

In der Figur 2 ist der Gesamtnutzen 4 nach dem Heraustrennen der Einzelnutzen 2 dargestellt. Es sind die Konturen der Einzelnutzen zu erkennen, ebenso die Metallanbindungen 3, die ein wenig in die Kontur der Einzelnutzen hineinragen. Es ist zu erkennen, dass die Metallanbindungen 3 nur abschnittsweise an dem Umfang der Einzelnutzen angeordnet sind und nur eine geringe Überdeckung mit den Einzelnutzen aufweisen, um ein leichtes Herausdrücken oder Entfernen der Einzelnutzen zu ermöglichen. Bei einigen Konturen sind die Metallanbindungen nicht dargestellt.

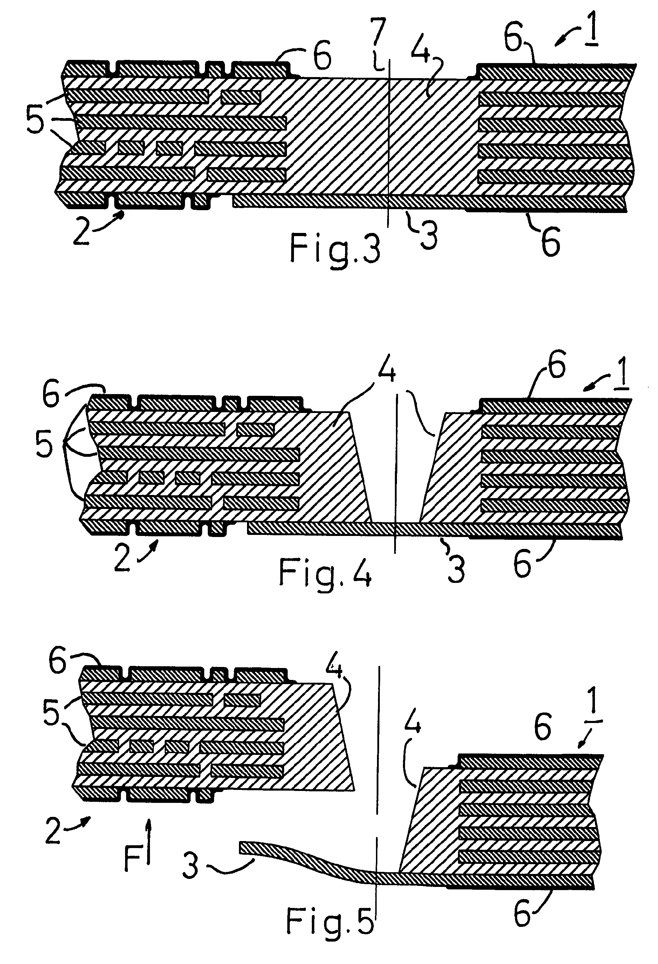

In der Figur 3 ist eine Schnittdarstellung durch einen Teil eines Gesamtnutzens 1 dargestellt. Innerhalb des Gesamtnutzens 1 ist ein Einzelnutzen 2 mit integrierten elektrischen Schaltungen 5 aus Kupfer dargestellt. Die einzelnen Schaltungen sind in dem elektrisch nicht leitenden Basismaterial 4 angeordnet und bilden insgesamt eine elektrische Leiterplatte. Der Einzelnutzen 2 ist in seinem Umfang vollständig von dem Leiterplattengrundmaterial 4 oder Basismaterial umgeben, die Konturlinie oder Umfangslinie ist mit dem Bezugszeichen 7 gekennzeichnet. Elektrische Schaltungen sind ebenfalls an der Oberseite und Unterseite des Leiterplattengrundmaterials 4 angeordnet, die mit einem Lötstopplack 6 versiegelt sind.

An der Unterseite des Gesamtnutzens ist eine Metallanbindung 3 vorgesehen, die über die Konturlinie 7 hinausragt und eine mechanische Verbindung zwischen dem Gesamtnutzen 1 und dem Einzelnutzen 2 herstellt. Die Metallanbindung 3, vorzugsweise ebenfalls aus einem Kupfermaterial und beispielsweise als ein Metallpad ausgebildet, überbrückt nur abschnittsweise die Konturlinie 7 und erstreckt sich nicht über den gesamten Umfang oder über die gesamte Oberfläche der Unterseite des Einzelnutzens 2.

In der Figur 4 ist der Zustand des Gesamtnutzens 1 nach dem Heraustrennen des Leiterplattengrundmaterials 4 entlang der Umfangslinie 7 dargestellt. Das Leiterplattengrundmaterial 4 wird vorzugsweise durch einen Laserstrahl, der nicht dargestellt ist, herausgeschnitten. Der Laserstrahl wird entlang der Konturlinie 7 um den Einzel-nutzen 2 herum geführt und verdampft das Leiterplattengrundmaterial 4. Der Laserstrahl wird dabei so eingestellt, dass er das Leiterplattengrundmaterial 4 vollständig entfernt, jedoch nicht die Metallanbindung 3 auf der Unterseite zerstört. Im Zustand der Figur 4 ist das gesamte Leiterplattengrundmaterial 4 entlang der Umfangslinie 7 entfernt, so dass die Einzelnutzen 2 ausschließlich über die Metallanbindungen 3 an dem Gesamtnutzen 1 festgelegt ist. Der Lötstopplack 6 deckt an den gewünschten Stellen die Oberfläche sowohl des Einzelnutzens 2 als auch des Gesamtnutzens 1 ab. Der Lötstopplack 6 wird üblicherweise erst nach dem Trennen durch den Laserstrahl aufgebracht.

In der Figur 5 ist der letzte Schritt des Herstellverfahrens gezeigt, bei dem durch Herausdrücken des Einzelnutzens 2, was durch den Pfeil F angedeutet ist, der Einzelnutzen 2 von dem Gesamtnutzen 1 getrennt wird. Vor oder nach dem Trennen des Einzelnutzens 2 aus dem Gesamtnutzen 1 kann eine Bestückung mit elektrischen oder elektronischen Komponenten erfolgen.

Während es bislang notwendig war, eine Leiterplatte aufwendig nachzuarbeiten, um Reste der Nutzenanbindung zu entfernen, ist es durch das vorgestellte Verfahren und den vorgestellten Leiterplattennutzen möglich, eine konturgenaue und splitterfreie Nutzenanbindung und Herstellung von Leiterplatten oder Einzelnutzen 2 zu er-möglichen. Selbst kleinste Einzelnuten können mit umlaufender Kontur so gefertigt werden, dass diese nach dem Nutzentrennen nicht nachgearbeitet werden müssen. Das Entfernen des Basismaterials oder Leiterplattengrundmaterials 4 mittels Laserstrahl verhindert, dass mechanische Spannungen in die Leiterplatte oder in den Einzelnutzen eingebracht wird, wodurch sich die Herstellgenauigkeit und Zuverlässigkeit der solcher Art hergestellten Einzelnutzen vergrößern lässt.

Durch die lediglich teilweise Anbindung der Einzelnutzen über die Metallanbindungen 3 an den Gesamtnutzen 1 ist es möglich, den Gesamtnutzen mit den darin enthaltenen Einzelnutzen auch nach dem Entfernen des Leiterplattengrundmaterials 4 zu handhaben, beispielsweise um weitere Bearbeitungsschritte wie das Bestücken vornehmen zu können. Eine Trennung der Einzelnutzen 2 aus dem Gesamtnutzen 1 kann aufgrund der geringen Bindungsfläche ohne Werkzeug erfolgen.

Durch die stressarme Trennung der Einzelnutzen 2 aus dem Gesamtnutzen 1 können Bauteile sehr nahe an den Rand des Einzelnutzens 2 gesetzt werden, so dass die Fläche der einzelnen Leiterplatten optimal ausgenutzt werden kann.

Durch das Anordnen der Metallanbindung 3 an der Oberfläche beispielsweise der Unterseite der Leiterplatten wird die Konturgebung der Leitplatte nicht gestört. Die Anbindung an den Gesamtnutzen 1 erfolgt somit unabhängig von dem Leiterplattendesign, so dass auch hier Optimierungspotenzial besteht. Vorteilhaft ist die Anordnung der Metallanbindungen 3 in Eckbereichen oder entlang von Seitenkanten, dort jedoch nur abschnittsweise. Eine Einzelnutzenanbindung über Kupferpads ist dabei bevorzugt.

## Patentansprüche

1. Verfahren zum Herstellen bestückter oder unbestückter Leiterplatten oder Einzelschaltungen als Einzelnutzen (2) aus einem Gesamtnutzen (1) mit einem Leiterplattengrundmaterial (4), bei dem der jeweilige Einzelnutzen (2) aus dem Gesamtnutzen (1) mit einem Laser entfernt wird, wobei vor dem Entfernen des Einzelnutzens (2) dieser über Metallanbindungen (3) an dem Gesamtnutzen (1) befestigt wird, **dadurch gekennzeichnet, dass** das Leiterplattengrundmaterial (4) bis auf die Metallanbindungen (3) entfernt und dass der Einzelnutzen (2) nach dem Entfernen des Leiterplattengrundmaterials (4) von dem Gesamtnutzen (1) getrennt, insbesondere herausgedrückt wird.

2. Verfahren nach Anspruch 1, **dadurch gekennzeichnet, dass** zum Entfernen des Leiterplattengrundmaterials (4) ein CO₂-Laser eingesetzt wird.

3. Verfahren nach Anspruch 1 oder 2, **dadurch gekennzeichnet, dass** die Metallanbindungen (3) an den Eckbereichen und/oder Teilbereichen der Kontur der Einzelnutzen (2) angebracht werden.

4. Verfahren nach einem der voranstehenden Ansprüche, **dadurch gekennzeichnet, dass** die Metallanbindungen (3) als Kupferanbindungen, insbesondere Kupferpads, aufgebracht werden.

5. Verfahren nach einem der voranstehenden Ansprüche, **dadurch gekennzeichnet, dass** die Metallanbindungen (3) auf einer Oberfläche des Gesamtnutzens (1) oder zwischen zwei Werkstofflagen des Leiterplattengrundmaterials (4) angeordnet werden.

6. Verfahren nach einem der der voranstehenden Ansprüche, **dadurch gekennzeichnet, dass** vor dem Trennen des Einzelnutzens (2) und nach dem Entfernen des Leiterplattengrundmaterials (4) eine Bearbeitung des Einzelnutzens (2), insbesondere eine Bestückung mit SMD, erfolgt.

7. Leiterplattengesamtnutzen mit einer Vielzahl von Einzelnutzen (2) bestückter oder unbestückter Leiterplatten oder Einzelschaltungen, **dadurch gekennzeichnet, dass** die Einzelnutzen (2) ausschließlich über zumindest eine Metallanbindung (3) an einem Leiterplattengrundmaterial (4) befestigt sind, wobei die Metallanbindungen (3) nur auf einer Seite des Gesamtnutzens (1) angeordnet sind.

8. Leiterplattengesamtnutzen nach Anspruch 7, **dadurch gekennzeichnet, dass** die Metallanbindung (3) als Metallfolie, insbesondere als Kupferfolie ausgebildet ist.

9. Leiterplattengesamtnutzen nach Anspruch 7 oder 8, **dadurch gekennzeichnet, dass** die Metallanbindung (3) nur Teile der Kontur des Einzelnutzens (2) überlappend angeordnet, insbesondere an Eckbereichen, ausgebildet ist.

10. Leiterplattengesamtnutzen nach einem der Ansprüche 7 bis 9, **dadurch gekennzeichnet, dass** die Metallanbindung (3) auf einer Oberfläche des Leiterplattengrundmaterials (4) angeordnet ist.

11. Leiterplattengesamtnutzen nach einem der Ansprüche 7 bis 10, **dadurch gekennzeichnet, dass** die Metallanbindung (3) als separate Komponente ohne Kontaktierung zu einer Schaltung ausgebildet ist.

## Claims

1. Method for producing populated or unpopulated circuit boards or individual circuits as individual panels (2) from a complete panel (1) having a circuit-board base material (4), wherein the respective individual panel (2) is removed from the complete panel (1) with a laser, wherein, before the removal of the individual panel (2), it is fastened to the complete panel (1) by way of metal connections (3), **characterized in that** the circuit-board base material (4) is removed apart from the metal connections (3) and **in that** the individual panel (2) is separated from the complete panel (1), in particular pressed out, after the removal of the circuit-board base material (4).

2. Method according to Claim 1, **characterized in that** a CO₂ laser is used for the removal of the circuit-board base material (4).

3. Method according to Claim 1 or 2, **characterized in that** the metal connections (3) are attached to the corner regions and/or partial regions of the contour of the individual panels (2).

4. Method according to one of the preceding claims, **characterized in that** the metal connections (3) are applied as copper connections, in particular copper pads.

5. Method according to one of the preceding claims, **characterized in that** the metal connections (3) are arranged on a surface of the complete panel (1) or between two layers of material of the circuit-board base material (4).

6. Method according to one of the preceding claims, **characterized in that**, before the separation of the individual panel (2) and after the removal of the circuit-board base material (4), a processing of the individual panel (2) is performed, in particular population with SMDs.

7. Complete circuit board panel having a multiplicity of individual panels (2) of populated or unpopulated circuit boards or individual circuits, **characterized in that** the individual panels (2) are fastened to a circuit-board base material (4) exclusively by way of at least one metal connection (3), wherein the metal connections (3) are arranged only on one side of the complete panel (1).

8. Complete circuit board panel according to Claim 7, **characterized in that** the metal connection (3) is formed as metal foil, in particular as copper foil.

9. Complete circuit board panel according to Claim 7 or 8, **characterized in that** the metal connection (3) is formed so as to be arranged overlapping only parts of the contour of the individual panel (2), in particular at corner regions.

10. Complete circuit board panel according to one of Claims 7 to 9, **characterized in that** the metal connection (3) is arranged on a surface of the circuit-board base material (4).

11. Complete circuit board panel according to one of Claims 7 to 10, **characterized in that** the metal connection (3) is formed as a separate component without being in electrical contact with a circuit.

## Revendications

1. Procédé de fabrication de cartes à circuits imprimés ou de circuits individuels équipés ou nus à titre de flan imprimé individuel (2) à partir d'un flan imprimé d'ensemble (1) avec un matériau de base de carte à circuits imprimés (4) dans lequel le flan imprimé individuel respectif (2) est retiré au laser depuis le flan imprimé d'ensemble (1), et avant de retirer le flan imprimé individuel (2), celui-ci est fixé au flan imprimé d'ensemble (1) par des attaches métalliques (3), **caractérisé en ce que** l'on retire le matériau de base (4) de la carte à circuits imprimés, exception faite des attaches métalliques (3), et **en ce que** l'on sépare le flan imprimé individuel (2) du flan imprimé d'ensemble (1), en particulier en le chassant sous pression, après avoir retiré le matériau de base (4) de la carte à circuits imprimés.

2. Procédé selon la revendication 1, **caractérisé en ce que** pour retirer le matériau de base (4) de la carte à circuits imprimés, on utilise un laser CO₂.

3. Procédé selon la revendication 1 ou 2, **caractérisé en ce que** l'on agence les attaches métalliques (3) dans les zones de coin et/ou dans des zones partielles du contour des flans imprimés individuels (2).

4. Procédé selon l'une des revendications précédentes, **caractérisé en ce que** l'on agence les attaches métalliques (3) sous forme d'attaches en cuivre, en particulier sous forme de pastilles de cuivre.

5. Procédé selon l'une des revendications précédentes, **caractérisé en ce que** l'on agence les attaches métalliques (3) sur une surface du flan imprimé d'ensemble (1) ou entre deux couches du matériau de base (4) de la carte à circuits imprimés.

6. Procédé selon l'une des revendications précédentes, **caractérisé en ce qu'**avant de séparer le flan imprimé individuel (2) et après avoir enlevé le matériau de base (4) de la carte à circuits imprimés, on procède au traitement du flan imprimé individuel (32), en particulier à l'assemblage des CMS (composants montés en surface).

7. Flan imprimé d'ensemble de carte à circuits imprimés, comportant une multitude de flans imprimés individuels (2) de cartes à circuits imprimés ou de circuits individuels équipés ou nus, **caractérisé en ce que** les flans imprimés individuels (2) sont fixés sur un matériau de base de circuit imprimé (4) exclusivement par au moins une attache métallique (3), les attaches métalliques (3) n'étant agencées que sur un côté du flan imprimé d'ensemble (1).

8. Flan imprimé d'ensemble selon la revendication 7, **caractérisé en ce que** l'attache métallique (3) est réalisée sous forme de feuille métallique, en particulier de feuille en cuivre.

9. Flan imprimé d'ensemble selon la revendication 7 ou 8, **caractérisé en ce que** l'attache métallique (3) est réalisée en chevauchant des parties seulement du contour du flan imprimé individuel (2), en particulier dans des zones en coin.

10. Flan imprimé d'ensemble selon l'une des revendications 7 à 9, **caractérisé en ce que** l'attache métallique (3) est agencée sur une surface du matériau de base (4) de la carte à circuits imprimés.

11. Flan imprimé d'ensemble selon l'une des revendications 7 à 10, **caractérisé en ce que** l'attache métallique (3) est réalisée sous forme de composante séparée sans mise en contact avec un circuit.
